Europäisches Patentamt

(19) European Patent Office

Office européen des brevets

(11) EP 0 825 709 A1

(12) EUROPEAN PATENT APPLICATION

(43) Date of publication:
25.02.1998 Bulletin 1998/09

(51) Int. Cl.6: H03F 1/02, H03G 1/00

(21) Application number: 97113783.1

(22) Date of filing: 08.08.1997

(84) Designated Contracting States:
AT BE CH DE DK ES FI FR GB GR IE IT LI LU MC NL PT SE

(30) Priority: 14.08.1996 JP 214576/96

(71) Applicant: NEC CORPORATION
Tokyo (JP)

(72) Inventor: Kagawa, Shigeru
Minato-ku, Tokyo (JP)

(74) Representative:
Glawe, Delfs, Moll & Partner
Patentanwälte
Postfach 26 01 62
80058 München (DE)

(54) Grounded-emitter amplifier circuit with an attenuator

(57) A grounded-emitter amplifier circuit with an attenuator is disclosed. As an attenuator, transistor for attenuation which is connected at the collector thereof to the base of transistor for amplification, at the emitter thereof to the ground and at the base thereof to attenuation control signal input terminal is provided. If an attenuation control signal of a high level is inputted to attenuation control signal input terminal, then transistor 5 for attenuation is turned on, and the base bias voltage of transistor 8 for amplification decreases.

FIG. 2

# Description

## Background of the Invention

### 1. Field of the Invention

This invention relates to a grounded-emitter amplifier circuit with an attenuator which includes a transistor for amplification grounded at the emitter.

### 2. Description of the Related Art

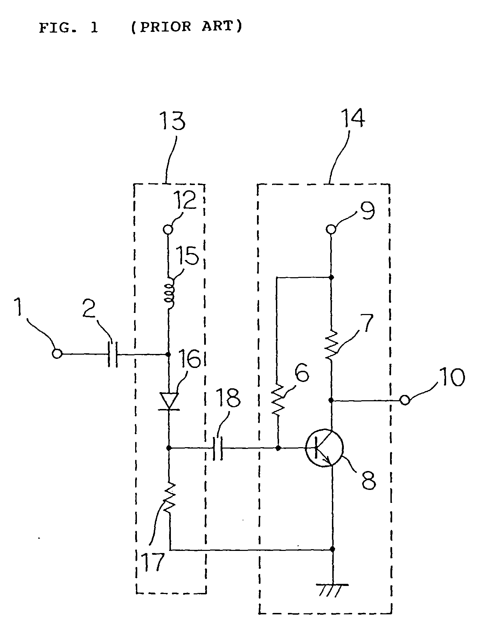

As shown in Fig. 1, a conventional grounded-emitter amplifier circuit with an attenuator comprises an attenuator unit 13, an amplifier unit 14, an input terminal 1, capacitors 2 and 18, and an output terminal 10.

The attenuator unit 13 consists of an attenuation control signal input terminal 12, a coil 15, a PIN diode 16, the impedance of which varies depending upon the amount of current, and a resistor 17. The amplifier unit 14 consists of a power supply terminal 9, resistors 6 and 7 and a transistor 8 for amplification.

An input signal inputted from input terminal 1 is supplied to capacitor 2, by which a dc component of the input signal is removed, and only an ac component of the input signal is inputted to attenuator unit 13. The ac component of the input signal is attenuated by attenuator unit 13 by the amount of attenuation determined according to a ratio between the impedance of PIN diode 16 and the impedance of resistor 17, after which it is outputted to capacitor 18. The amount of attenuation is controlled by varying the amount of current flowing through PIN diode 16 to vary the impedance of PIN diode 16. If the applied voltage to attenuation control signal input terminal 12 is changed, for example, from a high level to a low level, then the amount of current flowing through PIN diode 16 decreases and the impedance of the PIN diode 16 increases, so that the input signal is attenuated by PIN diode 16. The attenuated signal is then outputted to capacitor 18. The signal outputted to capacitor 18 is amplified by transistor 8 for amplification whose gain is determined according to a ratio between the emitter resistance and the resistance value of resistor 7, after which it is outputted to output terminal 10.

The conventional grounded-emitter amplifier circuit with an attenuator described above has the following disadvantages.

(1) Even if the input signal is attenuated to attenuate the output signal, since the amount of current flowing through the transistor for amplification does not vary, the current consumption does not decrease.
(2) Since a PIN diode is used as an attenuator unit, miniaturization of the circuit is impossible and hence the cost becomes high.

## Summary of the Invention

It is an object of the present invention to provide a grounded-emitter amplifier circuit with an attenuator which can attenuate an output signal without using a PIN diode and can decrease the current consumption upon attenuation.

In order to attain the object described above, a grounded-emitter amplifier circuit with an attenuator according to the present invention comprises, a transistor for amplification, grounded at the emitter thereof; and

means for reducing a base bias voltage of a transistor for amplification as an attenuator.

The present invention realizes a grounded-emitter amplifier circuit with an attenuator without using a PIN diode and decreases the base bias voltage of the transistor for amplification to attenuate the output signal.

Accordingly, the current consumption of a grounded-emitter amplifier circuit with an attenuator can be reduced. Further, since a PIN diode is not used, a grounded-emitter amplifier circuit with an attenuator which is low in cost and reduced in circuit scale can be provided.

According to an embodiment of the present invention, the means comprises a transistor for attenuation, an attenuation control signal input terminal and a resistor interposed between the base of said transistor for attenuation and said attenuation control signal input terminal, the collector of said transistor for attenuation being connected to the base of said transistor for amplification and the emitter of said transistor for attenuation being connected to the ground.

According to another embodiment of the present invention, a resistor is interposed between the base of said transistor for amplification and the collector of said transistor for attenuation.

The above and other objects, features, and advantages of the present invention will become apparent from the following description with references to the accompanying drawings which illustrate examples of the present invention.

## Brief Description of the Drawings

Fig. 1 is a circuit diagram of a conventional grounded-emitter amplifier circuit with an attenuator;
Fig. 2 is a circuit diagram of a grounded-emitter amplifier circuit with an attenuator of a first embodiment according to the present invention; and
Fig. 3 is a circuit diagram of a grounded-emitter amplifier circuit with an attenuator according to a second embodiment of the present invention.

## Detailed Description of the Preferred Embodiments

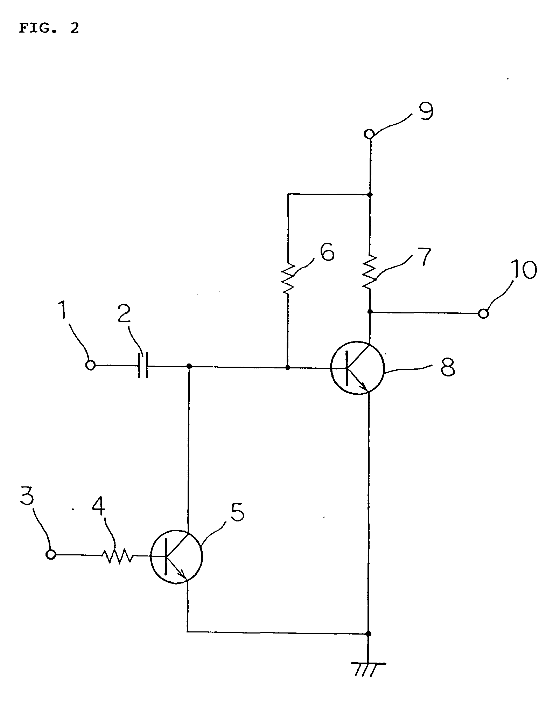

Referring now to Fig.2, a grounded-emitter amplifier circuit with an attenuator according to an embodiment of the present invention comprises an input terminal 1, a capacitor 2, an attenuation control signal input terminal 3, resistors 4, 6 and 7, a transistor 8 for amplification, a transistor 5 for attenuation, a power supply terminal 9 and an output terminal 10.

The dc component of an input signal inputted from input terminal 1 is removed by capacitor 2 and only the ac component of the input signal is inputted to the base of transistor 8. Resistor 6 is imposed between power supply terminal 9 and the base of transistor 8 and supplies a base bias voltage. Resistor 7 is imposed between power supply terminal 9 and the collector of transistor 8. Transistor 8 is grounded at the emitter thereof together with resistors 6 and 7 constitutes an amplification unit and outputs an amplified signal to output terminal 10. Resistor 4 is imposed between attenuation control signal input terminal 3 and the base of transistor 5 and limits the amount of the base current of transistor 5. The collector of the transistor 5 is connected to the base of transistor 8 and the emitter of the transistor 5 is connected to the ground. Transistor 5 and resistor 4 constitute an attenuator unit.

The operation of the present embodiment will be described hereinafter with reference to Fig. 2.

1) It is assumed that an attenuation control signal of a low level is inputted to attenuation control signal input terminal 3.

In this case, transistor 5 for attenuation exhibits an off-state. After a dc component of an input signal inputted from input terminal 1 is removed by capacitor 2, the input signal is amplified with a gain determined according to a ratio between the emitter resistance of transistor 8 and the resistance of resistor 7, and is outputted to output terminal 10. Since transistor 5 is off-state, base bias voltage $V_{BE1}$ of transistor 8 for amplification is approximately 0.7 V. When the emitter current of transistor 8 is represented by $I_{E1}$, then emitter resistance $r_{e1}$ of transistor 8 is expressed by following equation (1):

$$r_{e1} = V_T / I_{E1} \qquad (1)$$

where $V_T$ is the thermoelectric voltage, and $V_T = k \times T/q$, q is the charge quantity of an electron, k is the Boltzmann constant, and T is the absolute temperature.

2) It is assumed that an attenuation control signal of a high level is inputted to attenuation control signal input terminal 3:

In this case, since transistor 5 for attenuation exhibits an on-state, base bias voltage $V_{BE2}$ of transistor 8 becomes equal to saturation voltage $V_{CE(SAT)}$ of transistor 5 and is lower than 0.7 V. Accordingly, the amount of emitter current $I_{E2}$ of transistor 8 decreases from that in the case 1), and emitter resistance $r_{E2}$ of transistor 8 becomes larger than that in the case 1). If the resistance value of resistor 7 or the saturation voltage of transistor 5 is set so that this emitter resistance $r_{E2}$ may be larger than the resistance value of resistor 7, then transistor 8 serves as an attenuator.

This will be explained with concrete values, when the saturation voltage $V_{CE(SAT)}$ of transistor 5 is set so that the difference between $V_{BE1}$ and $V_{BE2}$ may be, for example, 100 mV, then $V_{BE1}$ and $V_{BE2}$ are expressed by the following equations (2)and (3), respectively:

$$V_{BE1} = V_T \times LOG_e(I_{E1}/I_S) \qquad (2)$$

$$V_{BE2} = V_T \times LOG_e(I_{E2}/I_S) \qquad (3)$$

where $I_S$ is the saturation current of transistor 8 when transistor 8 is biased reversely.

When equations (2) and (3) are substituted into $100\ mV = V_{BE1} - V_{BE2}$, the following equation is obtained:

$$100\ mV = V_T \times LOG_e(I_{E1}/I_{E2}) \qquad (4)$$

When $q = 1.602 \times 10^{-19}$ (C), $k = 1.38 \times 10^{-23}$ (J/K) and $T = 300$ (K) are substituted into $V_T = k \times T/q$, $V_T \doteqdot 26\ mV$ is obtained. From this value and equation (4), the following equations are obtained.

$$I_{E1}/I_{E2} \doteqdot 0.0214 \qquad (5)$$

$$r_{e2}/r_{e1} \doteqdot 33\ (dB) \qquad (6)$$

Accordingly, when transistor 5 is turned on to attenuate the output signal, according to the equation (5), the current consumption is reduced to 2 %, and according to the equation (6), the amount of attenuation is 33 (dB).

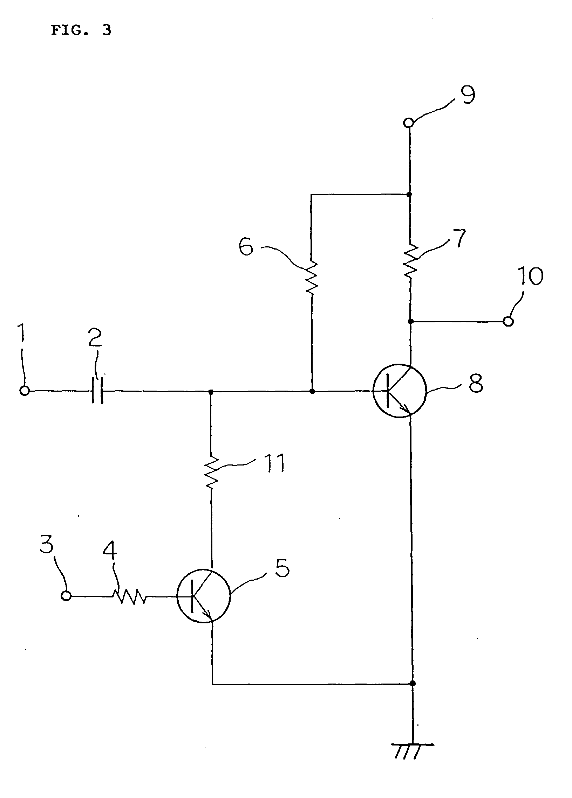

Referring to Fig. 3, a circuit diagram of a grounded-emitter amplifier circuit with an attenuator of a second embodiment according to the present invention is shown. The present embodiment, differs from the first embodiment in that, resistor 11 is interposed between the collector of transistor 5 and the base of transistor 8. By setting the resistance value of this resistor 11 to various values, the setting range of the base bias voltage of transistor 8 upon attenuation is expanded, and therefor the range within which the amount of attenuation can be adjusted is expanded.

While preferred embodiments of the present invention have been described using specific terms, such description is for illustrative purposes only, and it is to be understood that changes and variations may be made without departing from the spirit or scope of the following claims.

**Claims**

1. A grounded-emitter amplifier circuit comprising: a transistor for amplification , grounded at the emitter thereof; and means for reducing a base bias voltage of said transistor for amplification as an attenuator.

2. A grounded-emitter amplifier circuit with an attenuator as set forth in claim 1, wherein said means for reducing a base bias voltage of said transistor for amplification comprises a transistor for attenuation, whose collector is connected to the base of said transistor for amplification, base is connected to an attenuation control signal input terminal through a resistor and emitter is grounded.

3. A grounded-emitter amplifier circuit with an attenuator as set forth in claim 2, wherein a resistor is interposed between the base of said transistor for amplification and the collector of said transistor for attenuation.

FIG. 1    (PRIOR ART)

FIG. 2

FIG. 3

**European Patent Office**

# EUROPEAN SEARCH REPORT

Application Number

EP 97 11 3783

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 599 327 A (NIPPON ELECTRIC CO) * column 5, line 10 - line 40; claims 1,2; figure 5 * | 1-3 | H03F1/02 H03G1/00 |
| X | GB 952 904 A (TELEFUNKEN) * page 2, line 51 - line 80; figure 1 * | 1,2 | |
| Y | EP 0 398 039 A (MOTOROLA INC) * page 3, line 37 - line 53; figure 1 * | 1,2 | |
| Y | US 3 430 155 A (HARWOOD LEOPOLD A) * column 3, line 66 - column 4, line 37; figure 3 * | 1-3 | |
| Y | US 4 498 056 A (KWITKOWSKI PETER A  ET AL) * column 2, line 46 - column 3, line 26; figure 1 * | 3 | |
| A | US 4 305 044 A (LEIDICH ARTHUR J) * abstract; figure 1 * | 1,2 | |
| A | US 3 708 756 A (FAJEN L) * abstract; figure 1 * | 1 | TECHNICAL FIELDS SEARCHED (Int.Cl.6) H03F H03G H03H |

The present search report has been drawn up for all claims

| Place of search | Date of completion of the search | Examiner |
|---|---|---|
| BERLIN | 19 November 1997 | Breusing, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)